# EUROPEAN PATENT APPLICATION

(11) **EP 4 362 115 A1**
(43) Date of publication of application: **01.05.2024**
(21) Application number: 22828226.5
(22) Date of filing: 08.06.2022
(51) Int. Cl.: H01L 33/16, H01L 33/32, H01L 21/20, H01L 21/306, C30B 29/38, C23C 16/34

(54) **SEMICONDUCTOR DEVICE MANUFACTURING METHOD AND MANUFACTURING DEVICE, SEMICONDUCTOR DEVICE AND ELECTRONIC DEVICE**

(30) Priority: 21.06.2021 JP 2021102585
(71) Applicant: Kyocera Corporation, Kyoto-shi Kyoto 612-8501 (JP)
(72) Inventor: MURAKAWA, Kentaro, Kyoto-shi, Kyoto 612-8501 (JP); KAMIKAWA, Takeshi, Kyoto-shi, Kyoto 612-8501 (JP)
(74) Representative: Viering, Jentschura & Partner mbB Patent- und Rechtsanwälte
(86) International application number: PCT/JP2022/023088
(87) International publication number: WO 2022/270309

(57) **Abstract**

A manufacturing method of a semiconductor device includes a step of preparing a template substrate including a main substrate and a mask pattern located above the main substrate and including a mask portion and an opening portion, a step of forming a first semiconductor part on the mask pattern by using an ELO method, a step of removing a portion of the main substrate overlapping the opening portion in plan view; and, a step of removing a portion of the first semiconductor part overlapping the opening portion in plan view.

## Description

### TECHNICAL FIELD

The present disclosure relates to a manufacturing method of a semiconductor device.

### BACKGROUND OF INVENTION

Patent Document 1 discloses a method in which a through-hole is formed in a sapphire substrate and a GaN buffer layer grown on the sapphire substrate, and an electrode in contact with a GaN contact layer through the through-hole is taken out to the bottom side of the sapphire substrate.

### CITATION LIST

### PATENT LITERATURE

Patent Document 1: JP 11-45892 A

### SUMMARY

A manufacturing method of a semiconductor device according to the present disclosure includes a step of preparing a template substrate including a main substrate and a mask pattern located above the main substrate and including a mask portion and an opening portion, a step of forming a first semiconductor part on the mask pattern by using an ELO method, a step of removing a portion of the main substrate overlapping the opening portion in plan view and a step of removing a portion of the first semiconductor part overlapping the opening portion in plan view.

### BRIEF DESCRIPTION OF THE DRAWINGS

FIG. 1 is a cross-sectional view illustrating a configuration of a semiconductor device according to the present embodiment.
FIG. 2 is a flowchart illustrating an example of a manufacturing method of a semiconductor device according to the present embodiment.
FIG. 3 is a cross-sectional view illustrating an example of the manufacturing method of the semiconductor device according to the present embodiment.
FIG. 4 is a block diagram illustrating an example of a manufacturing apparatus of a semiconductor device according to the present embodiment.
FIG. 5 is a cross-sectional view illustrating a configuration of a semiconductor device according to Example 1.
FIG. 6 is a cross-sectional view illustrating a configuration of an electronic device according to Example 1.
FIG. 7 is a flowchart illustrating an example of a manufacturing method of a semiconductor device according to Example 1.
FIG. 8 is a cross-sectional view illustrating an example of the manufacturing method of the semiconductor device according to Example 1.
FIG. 9 is a plan view illustrating an example of the manufacturing method of the semiconductor device according to Example 1.
FIG. 10 is a plan view illustrating an example of the manufacturing method of the semiconductor device according to Example 1.
FIG. 11 is a cross-sectional view illustrating an example of the manufacturing method of the semiconductor device according to Example 1.
FIG. 12 is a cross-sectional view illustrating an example of the manufacturing method of the semiconductor device according to Example 1.
FIG. 13 is a plan view illustrating an example of the manufacturing method of the semiconductor device according to Example 1.
FIG. 14 is a cross-sectional view illustrating another example of the manufacturing method of the semiconductor device according to Example 1.
FIG. 15 is a cross-sectional view illustrating another example of the manufacturing method of the semiconductor device according to Example 1.
FIG. 16 is a flowchart illustrating an example of a manufacturing method of a semiconductor device according to Example 2.
FIG. 17 is a cross-sectional view illustrating an example of the manufacturing method of the semiconductor device according to Example 2.
FIG. 18 is a cross-sectional view illustrating another example of the manufacturing method of the semiconductor device according to Example 2.
FIG. 19 is a cross-sectional view illustrating another example of the manufacturing method of the semiconductor device according to Example 2.
FIG. 20 is a flowchart illustrating another example of the manufacturing method of the semiconductor device according to Example 2.
FIG. 21 is a cross-sectional view illustrating another example of the manufacturing method of the semiconductor device according to Example 2.
FIG. 22 is a flowchart illustrating an example of a manufacturing method of a semiconductor device according to Example 3.
FIG. 23 is a cross-sectional view illustrating an example of the manufacturing method of the semiconductor device according to Example 3.

### DESCRIPTION OF EMBODIMENTS

### Semiconductor Device

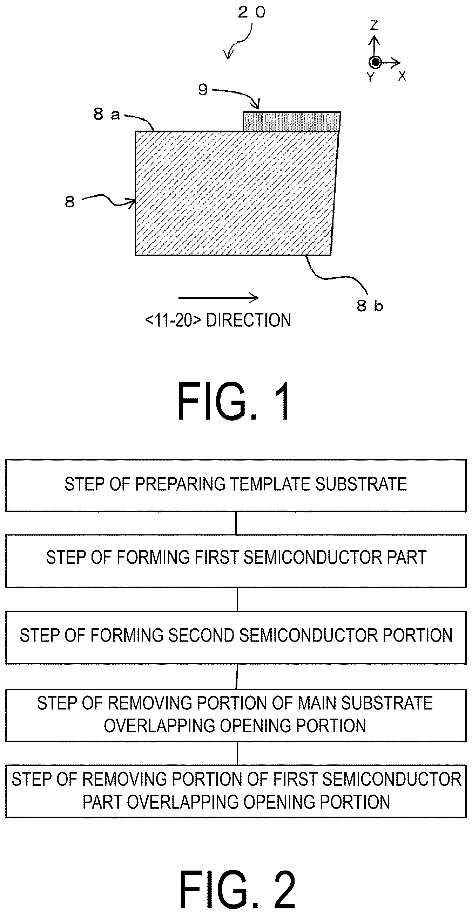

FIG. 1 is a cross-sectional view illustrating a configuration of a semiconductor device according to the present embodiment. As illustrated in FIG. 1, a semiconductor device 20 according to the present embodiment includes a first semiconductor part 8 and a second semiconductor part 9 that is located on an upper layer of (above) the first semiconductor part 8 and includes an active layer. The first semiconductor part 8 may be a first semiconductor layer containing a nitride semiconductor (for example, a GaN-based semiconductor), and the second semiconductor part 9 may be a second semiconductor layer containing a nitride semiconductor. The first semiconductor part 8 includes an upper surface 8a that is a (0001) plane, and a lower surface 8b that is a (000-1) plane. In the semiconductor device 20, the length of the upper surface 8a in a <11-20> direction may be greater than the length of the upper surface 8b in the <11-20> direction. This facilitates a manufacturing process of the semiconductor device 20.

### Manufacturing Semiconductor Device

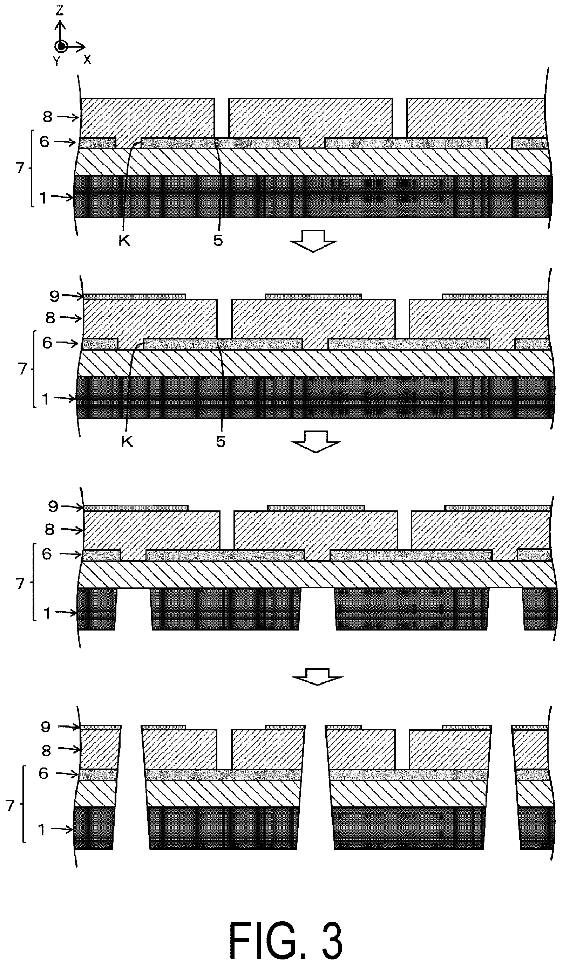

FIG. 2 is a flowchart illustrating an example of a manufacturing method of a semiconductor device according to the present embodiment. FIG. 3 is a cross-sectional view illustrating an example of the manufacturing method of the semiconductor device according to the present embodiment. In the manufacturing method of the semiconductor device in FIG. 2 and FIG. 3, after a step of preparing a template substrate 7 (substrate for ELO growth), the first semiconductor part 8 is formed on the template substrate 7 including a mask pattern 6 including a mask portion 5 and opening portions K by using an ELO method. Next, a step of forming a second semiconductor part 9 is performed. Thereafter, a step of removing a portion of the main substrate 1 overlapping the opening portions K of the mask pattern 6 in plan view is performed by etching the main substrate 1 from the back surface thereof. Thereafter, a step of removing portions of the first semiconductor part 8 each overlapping a respective one of the opening portions K of the mask pattern 6 in plan view is performed. This can facilitate separation of the semiconductor device from the template substrate 7. "Two members overlap each other in plan view" means that "at least a part of one member overlaps the other member in plan view (including a perspective plan view) viewed in the normal direction of the main substrate 1".

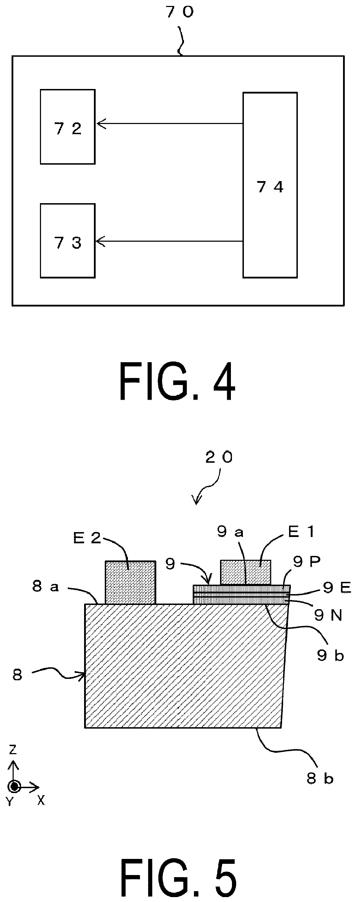

FIG. 4 is a block diagram illustrating an example of a manufacturing apparatus of the semiconductor device according to the present embodiment. A manufacturing apparatus 70 of the semiconductor device illustrated in FIG. 4 includes a former 72 forming a first semiconductor part 8 and a second semiconductor part9 on the template substrate 7, a machining portion 73 performing etching to the main substrate 1 from the back surface of the main substrate 1, and a controller 74 controlling the former 72 and the machining portion 73.

The former 72 may include a metal organic chemical vapor deposition (MOCVD) device, and the controller 74 may include a processor and a memory. The controller 74 may be configured to control the former 72 and the machining portion 73 by executing a program stored in a built-in memory, a communicable communication device, or an accessible network, for example. The program and a recording medium storing the program are also included in the present embodiment.

### Example 1

### Overall Configuration

FIG. 5 is a cross-sectional view illustrating a configuration of a semiconductor device according to Example 1. As illustrated in FIG. 5, a semiconductor device 20 according to Example 1 includes a first semiconductor part 8, a second semiconductor part 9 located on the first semiconductor part 8 and including an n-type semiconductor layer 9N, an active layer 9E, and a p-type semiconductor layer 9P, a first electrode E1 located on the p-type semiconductor layer 9P, and a second electrode E2 located on the first semiconductor part 8. The active layer 9E is, for example, a light emitting layer. The first electrode E1 is an anode. The second semiconductor part 9 is provided on the first semiconductor part 8, but the second semiconductor part 9 is not formed on a part of the first semiconductor part 8, and the second electrode E2 that is a cathode may be provided so as to be in contact with the part of the first semiconductor part 8.

The first semiconductor part 8 contains, for example, a nitride semiconductor (for example, a GaN-based semiconductor). The nitride semiconductor may be expressed, for example, by AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. In FIG. 5, a <0001> direction (thickness direction, c-axis direction) of the GaN-based semiconductor can be defined as the Z direction, a <11-20> direction (a-axis direction) of the GaN-based semiconductor can be defined as the X direction, and a <1-100> direction (m-axis direction) of the GaN-based semiconductor can be defined as the Y direction.

The first semiconductor part 8 can be formed by an epitaxial lateral overgrowth (ELO) method. The first semiconductor part 8 may contain an n-type dopant such as Si. The first semiconductor part 8 includes the upper surface 8a that is the (0001) plane, and the lower surface 8b that is the (000-1) plane. The second semiconductor part 9 includes an upper surface 9a that is the (0001) plane, and a lower surface 9b that is the (000-1) plane.

In the semiconductor device 20, the length of the upper surface 8a of the first semiconductor part 8 in the <11-20> direction (X-direction) may be greater than the length of the lower surface 8b in the <11-20> direction (X-direction). The length of the upper surface 9a of the second semiconductor part 9 (p-type semiconductor layer 9P) in the <11-20> direction (X-direction) may be greater than the length of the lower surface 9b of the second semiconductor part 9 (n-type semiconductor layer 9N) in the <11-20> direction (X-direction). This facilitates a manufacturing process of the semiconductor device 20 (described below).

Specific examples of the semiconductor device 20 include a light emitting diode (LED), a semiconductor laser, a Schottky diode, a photodiode, and transistors (including a power transistor and a high electron mobility transistor).

### Electronic Device

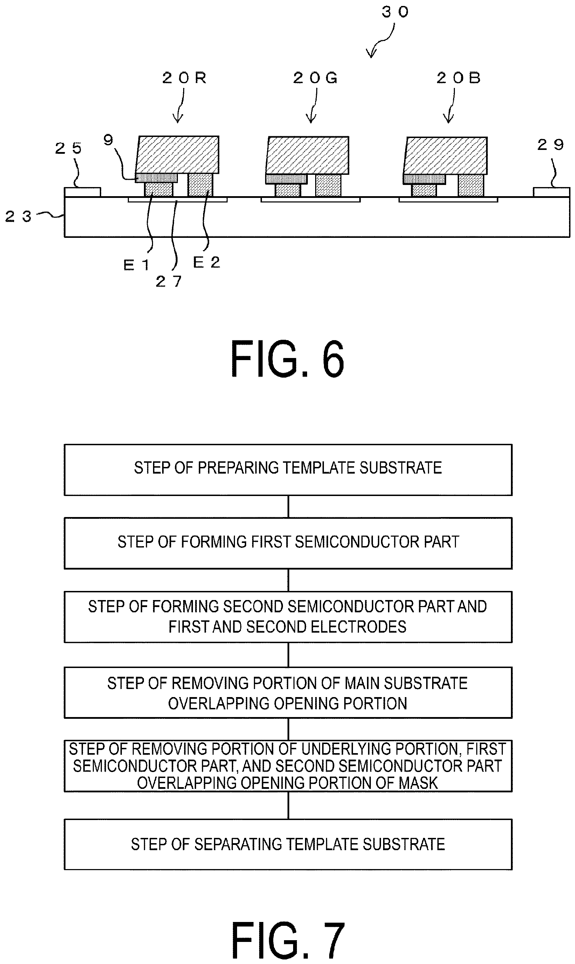

FIG. 6 is a cross-sectional view illustrating a configuration of an electronic device according to Example 1. As illustrated in FIG. 6, a micro LED display 30 (electronic device) includes the above-described semiconductor devices 20 each fabricated as a respective one of a red micro LED 20R, a green micro LED 20G, and a blue micro LED 20B. The micro LED display 30 includes a drive substrate 23 on which the semiconductor devices 20 are mounted, a control circuit 25 controlling the drive substrate 23, and a driver circuit 29 driving the semiconductor devices 20. The red micro LED 20R, the green micro LED 20G, and the blue micro LED 20B are each mounted on a respective one of a plurality of pixel circuits 27 of the drive substrate 23 by a conductive resin (for example, an anisotropic conductive resin) or the like. The drive substrate 23 may include a part of the driver circuit 29.

Examples of the electronic device include, in addition to the micro LED display 30, display devices, laser emitting devices (including a Fabry-Perot type and a surface emitting type), lighting devices, communication devices, information processing devices, sensing devices, and electrical power control devices.

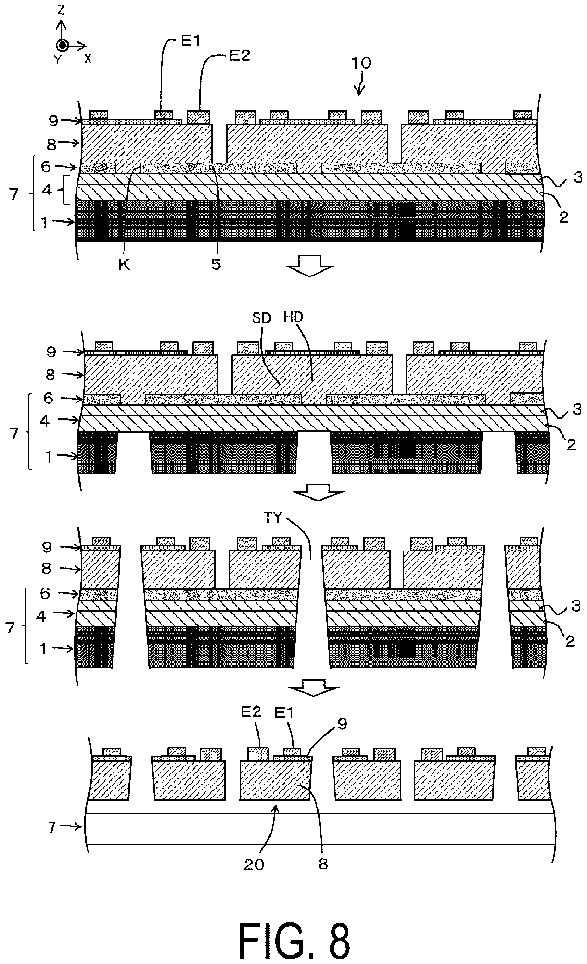

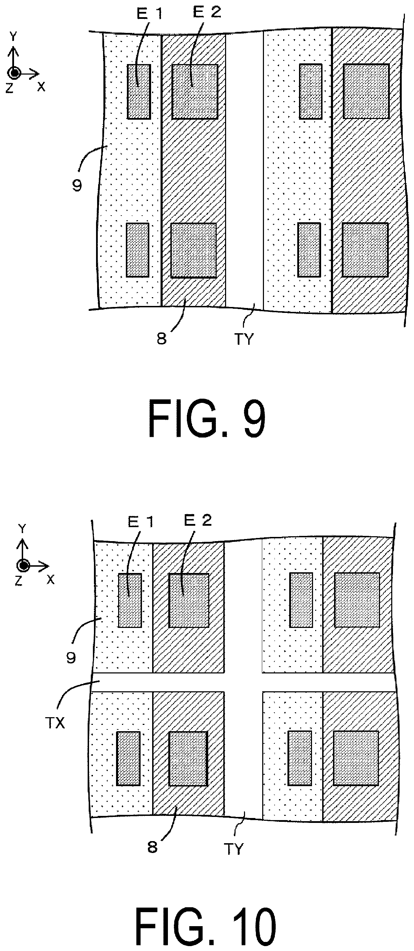

FIG. 7 is a flowchart illustrating an example of a manufacturing method of a semiconductor device according to Example 1. FIG. 8 is a cross-sectional view illustrating an example of the manufacturing method of the semiconductor device according to Example 1. FIG. 9 and FIG. 10 are plan views each illustrating an example of the manufacturing method of the semiconductor device according to Example 1.

In the manufacturing method of the semiconductor device in FIG. 7 and FIG. 8, a step of preparing the template substrate (substrate for ELO growth) 7 is performed. The template substrate 7 includes the main substrate 1, an underlying portion 4, and the mask pattern 6 in this order, and the mask pattern 6 includes the mask portion 5 and the opening portions K. Thereafter, the first semiconductor part 8 is formed on the template substrate 7 by using the ELO method. Next, a step of forming the second semiconductor part 9 and the first and second electrodes E1 and E2 is performed. As a result, a semiconductor substrate 10 is formed.

Thereafter, a step of removing a portion of the main substrate 1 overlapping the opening portions K of the mask pattern 6 in plan view is performed by etching (depth etching) the main substrate 1 from the back surface thereof. Before etching the main substrate 1, the thickness of the main substrate 1 may be reduced by back surface polishing of the main substrate 1 or the like. This causes the etching depth to be reduced and the etching accuracy is improved.

Thereafter, using the remaining portion of the main substrate 1 as an etching mask, a step of removing portions of the underlying portion 4, the first semiconductor part 8, and the second semiconductor part 9 overlapping a respective one of the opening portions K of the mask pattern 6 in plan view to form trenches TY extending in the Y direction is performed. In this step, a coupling portion between the underlying portion 4 (seed portion 3) and the first semiconductor part 8 is removed. A partial removal of the second semiconductor part 9 may be performed subsequently (consecutively) to the partial removal of the first semiconductor part 8. The etching in this step may be dry etching or wet etching. In the case of the dry etching, side etching can be suppressed. Phosphoric acid, a phosphoric acid mixture solution, or the like can be used for the wet etching.

The GaN-based semiconductor includes an N plane (lower surface) and a Ga plane (upper surface) that are polar planes in the c-axis direction, and has a characteristic that an etching rate from the N plane ((000-1) plane) being the lower surface is higher than an etching rate from the Ga plane ((0001) plane) that is the upper surface. By performing etching (particularly, dry etching) from the back surface (lower surface) of the first semiconductor part 8, the speed and accuracy of the etching can be increased. The back surface (lower surface) of the first semiconductor part 8 is not limited to the polar plane. A semipolar plane tilted from the c-plane may be used. A combined plane between the polar plane and the semipolar plane may be used. In FIG. 9, the trench TY extending in the Y direction is formed but as illustrated in FIG. 10, a trench TX extending in the X direction may be formed in the same step as the formation of the trench TY.

Thereafter, a step of separating the template substrate 7 and the first semiconductor part 8 is performed. An adhesion force between the mask portion 5 and the first semiconductor part 8 is weak (mainly due to the Van der Waals force), and thus the first semiconductor part 8 can be peeled from the mask portion 5 in a state where the first and second semiconductor parts 8 and 9 and the like are adhered to a flexible adhesive sheet, for example. That is, the template substrate 7 and the first semiconductor part 8 are easily separated from each other. As a result, the first and second semiconductor parts 8 and 9 and the like are singulated to form a plurality of the semiconductor devices 20. The trench TY has a tapered shape tapering upward (in the direction from the main substrate 1 to the mask pattern 6), and thus in the semiconductor device 20, the length of the upper surface 8a of the first semiconductor part in the <11-20> direction (X-direction) is greater than the length of the lower surface 8b of the first semiconductor part in the <11-20> direction (X-direction). The length of the upper surface 9a of the second semiconductor part in the <11-20> direction (X-direction) is greater than the length of the lower surface 9b of the second semiconductor part in the <11-20> direction (X-direction).

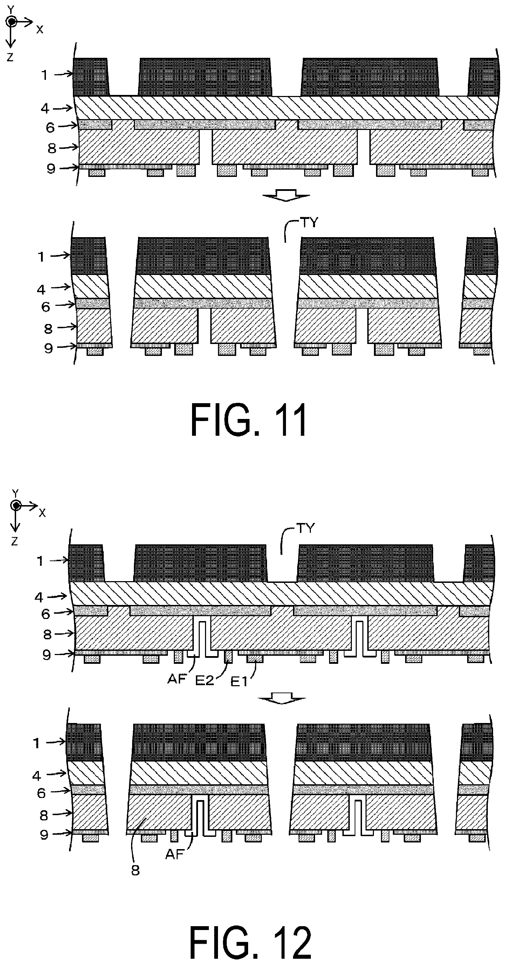

FIG. 11 and FIG. 12 are cross-sectional views each illustrating an example of the manufacturing method of the semiconductor device according to Example 1. The step of removing the portions of the first semiconductor part 8 overlapping a respective one of the opening portions K of the mask pattern 6 in plan view may be performed in a state where the main substrate 1 is on the vertically upper side as illustrated in FIG. 11. In this case, as illustrated in FIG. 12, anchor films AF (for example, inorganic insulating films such as a silicon oxide film or a silicon nitride film) may be formed in contact with the upper surface ((0001) plane) and the side surface of the first semiconductor part 8 and the mask portion 5. This reduces the possibility that the first semiconductor part 8 falls from the mask pattern 6 when the coupling portion between the first semiconductor part 8 and the underlying portion 4 is removed.

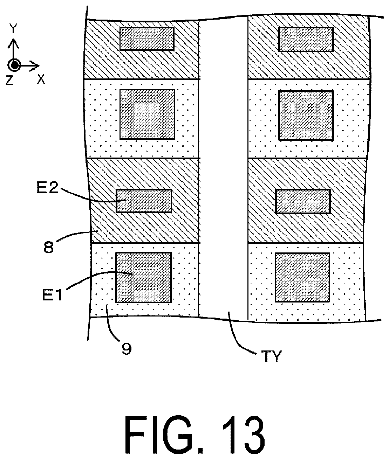

FIG. 13 is a plan view illustrating an example of the manufacturing method of the semiconductor device according to Example 1. In FIG. 8 and FIG.9, the first and second electrodes E1 and E2 are aligned in the X direction, but the configuration is not limited thereto. As in FIG. 13, the first and second electrodes E1 and E2 may be aligned in the Y direction. The area of the first electrode E1 may be greater than the area of the second electrode E2.

### Main Substrate

A heterogeneous substrate having a different lattice constant from that of a GaN-based semiconductor may be used for the main substrate 1. Examples of the heterogeneous substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate. These are merely examples, and any main substrate and any plane orientation may be used as long as the first semiconductor part 8 can be grown by the ELO method. The main substrate 1 is not limited to the heterogeneous substrate, and may be a GaN substrate (bulk).

### Underlying Portion

As illustrated in FIG. 8, as the underlying portion 4, a buffer portion 2 and the seed portion 3 may be provided in order from the main substrate 1 side. The underlying portion 4 may be an underlying layer. The buffer portion 2 may be a buffer layer. The seed portion 3 may be a seed layer.

The buffer portion 2 has, for example, a function of reducing the likelihood of the main substrate 1 and the seed portion 3 coming into direct contact with each other and melting together. For example, when a silicon substrate is used for the main substrate 1 and a GaN-based semiconductor is used for the seed portion 3, since the both (the main substrate and the seed layer) melt together, the melting is reduced by providing the buffer portion 2 containing at least one of the AlN layer and a silicon carbide (SiC) layer, for example.

The AlN layer being an example of the buffer portion 2 can be formed using an MOCVD device, for example, to have a thickness of from about 10 nm to about 5 µm. The buffer portion 2 may have the effect of enhancing the crystallinity of the seed portion 3 and/or the effect of relaxing the internal stress of the first semiconductor part 8 (relaxing the warp of the semiconductor substrate 10). When the main substrate 1 unlikely to melt with the seed portion 3 is used, the buffer portion 2 may not be provided.

The buffer portion 2 (for example, aluminum nitride) and/or the seed portion 3 (for example, GaN-based semiconductor) may be film-formed using a sputtering device (PSD: pulse sputter deposition, PLD: pulsed laser deposition, or the like).

### Mask Pattern

The opening portion K of the mask pattern 6 has a function of a growth start hole to expose the seed portion 3 and start the growth of the first semiconductor part 8. The mask portion 5 has a function of a selective growth mask to cause the first semiconductor part 8 to grow in the lateral direction. The mask pattern 6 may be a mask layer 6. The opening portion K may be a portion where the mask portion 5 is not provided, or the opening portion K need not be surrounded by the mask portion 5.

Examples of the mask portion 5 that can be used include a single-layer film including any one of a silicon oxide film (SiOx), a titanium nitride film (TiN or the like), a silicon nitride film (SiNx), a silicon oxynitride film (SiON), and a metal film having a high melting point (for example, 1000°C or higher), or a layered film including at least two thereof.

For example, a silicon oxide film having a thickness of from about 100 nm to about 4 µm (preferably from about 150 nm to about 2 µm) is formed on the entire surface of the underlying portion 4 by using sputtering, and a resist is applied onto the entire surface of the silicon oxide film. Thereafter, the resist is patterned by photolithography to form the resist having a plurality of stripe-shaped opening portions. Thereafter, a part of the silicon oxide film is removed by a wet etchant such as hydrofluoric acid (HF), buffered hydrofluoric acid (BHF), or the like to form the plurality of opening portions (including K), and the resist is removed by organic cleaning to form the mask pattern 6.

The opening portions K each have a rectangular shape (slit shape) and are periodically aligned in the a-axis direction (X direction) of the first semiconductor part 8. The width of the opening portion K is from about 0.1 µm to about 20 µm. The smaller the width of each of the opening portions K, the smaller the number of threading dislocations propagating from each of the opening portions K to the first semiconductor part 8. This allows the low-defect portion in the first semiconductor part 8 to be increased.

The silicon oxide film may be decomposed and evaporated in a small amount during film formation of the first semiconductor part 8 and may be taken into the first semiconductor part 8, but the silicon nitride film and the silicon oxynitride film have an advantage in terms of being hardly decomposed and evaporated at a high temperature.

The mask portion 5 may be a single-layer film of a silicon nitride film or a silicon oxynitride film. The mask portion 5 may be a layered film in which a silicon oxide film and a silicon nitride film are formed in that order on the underlying portion 4. The mask portion 5 may be a laminate body film in which a silicon nitride film and a silicon oxide film are formed in that order on the underlying portion 4. The mask portion 5 may be a layered film in which a silicon nitride film, a silicon oxide film, and a silicon nitride film are formed in that order on the underlying layer.

An abnormal portion such as a pinhole in the mask portion 5 may be eliminated by performing organic cleaning or the like after film formation and introducing the film again into a film forming device to form the same type of film. The mask pattern 6 with a high quality may be formed by using a general silicon oxide film (single layer) and using the above-described re-film formation method.

### Template Substrate

A silicon substrate having the (111) plane was used as the main substrate 1, and the buffer portion 2 of the underlying portion 4 was an AlN layer (for example, 30 nm). The seed portion 3 of the underlying portion 4 was a graded layer in which an Al_{0.6}Ga_{0.4}N layer (for example, 300 nm) as a first layer and a GaN layer (for example, from 1 µm to 2 µm) as a second layer were formed in that order.

As the mask portion 5, a laminate body in which a silicon oxide film (SiO₂) and a silicon nitride film (SiN) were formed in that order was used. The silicon oxide film had a thickness of, for example, 0.3 µm, and the silicon nitride film had a thickness of, for example, 70 nm. Each of the silicon oxide film and the silicon nitride film was film-formed by a plasma chemical vapor deposition (CVD) method.

### First Semiconductor Part

The first semiconductor part 8 includes a low dislocation portion SD overlapping the mask portion 5 in plan view, and having relatively few threading dislocations, and a high dislocation portion HD overlapping the opening portion K of the mask pattern 6 in plan view and having relatively many threading dislocations than the low dislocation portion SD, which are formed by an epitaxial lateral overgrowth (ELO) method (see FIG. 8). A threading dislocation density of the low dislocation portion SD may be one fifth or less of a threading dislocation density of the high dislocation portion HD. The threading dislocation density of the low dislocation portion SD may be 5 × 10⁶/cm² or less. The low dislocation portion SD may have a non-threading dislocation density greater than the threading dislocation density.

The threading dislocation is a dislocation (defect) extending from the lower surface or inside of the first semiconductor part 8 to the surface or surface layer thereof along the thickness direction (Z direction) of the first semiconductor part 8. Cathode luminescence (CL) measurement on the surface layer (parallel to the c-plane) of the first semiconductor part 8 allows observation of the threading dislocation. The non-threading dislocation is a dislocation that is subjected to CL measurement in a cross section taken along a plane parallel to the thickness direction (m-plane, for example), and is mainly a basal plane (c-plane) dislocation.

The light emission efficiency of the active layer 9E can be enhanced by overlapping a light emitting region (portion under the anode) of the active layer 9E with the low dislocation portion SD in plan view. This is because the portion of the second semiconductor part 9 overlapping the low dislocation portion SD in plan view inherits a low dislocation property of the first semiconductor part 8.

In Example 1, the first semiconductor part 8 was a GaN layer, and ELO film formation of gallium nitride (GaN) was performed on the above-described template substrate 7 by using the MOCVD device included in the former 72. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In this case, the first semiconductor part 8 is selectively grown (longitudinal growth) on the seed portion 3 (the GaN layer that is the second layer) exposed in the opening portion K, and is subsequently laterally grown on the mask portion 5. The lateral growth was stopped before the first semiconductor parts 8 laterally grown from both sides of the mask portion 5 are associated with each other.

A width Wm of the mask portion 5 was 50 µm, the width of the opening portion K was 5 µm, a lateral width of the first semiconductor part 8 was 53 µm, a width (size in the X direction) of the low defect portion was 24 µm, and a layer thickness of the first semiconductor part 8 was 5 µm. An aspect ratio of the first semiconductor part 8 was 53 µm/5 µm = 10.6, and a very high aspect ratio was achieved.

In the formation of the first semiconductor part 8 in Example 1, the lateral film formation rate is increased. A method for increasing the lateral film formation rate is as follows. First, a longitudinal growth layer that grows in the Z direction (c-axis direction) is formed on the seed portion 3 exposed from the opening portion K, and then a lateral growth layer that grows in the X direction (a-axis direction) is formed. In this case, by setting the thickness of the longitudinal growth layer to 10 µm or less, preferably 5 µm or less, and more preferably 3 µm or less, the thickness of the lateral growth layer may be suppressed to be thin and the lateral film formation rate may be increased.

### Second Semiconductor Part and Electrode

As illustrated in FIG. 5, the second semiconductor part 9 includes the n-type semiconductor layer 9N, the active layer 9E, and the p-type semiconductor layer 9P in this order from the bottom layer side. The active layer 9E is, for example, a Multi-Quantum Well (MQW: InGaN/GaN) structure and contains InGaN or GaN. The n-type semiconductor layer 9N is, for example, an AlGaN layer. The GaN-based p-type semiconductor layer 9P is, for example, a GaN layer. The first electrode E1 that is the anode is disposed so as to be in contact with the p-type semiconductor layer 9P.

The first and second semiconductor parts 8 and 9 may be continuously formed in the same device (for example, an MOCVD device), or after the first semiconductor part 8 is formed, the substrate is temporarily taken out of the device, and the surface polishing of the first semiconductor part 8 is performed, and the second semiconductor part 9 may be formed. In addition to the MOCVD device, a sputtering device, a remote plasma CVD device (RPCVD), or a pulse sputter deposition (PSD) device can be used for the formation of the second semiconductor part 9. The remote plasma CVD device and the PSD device do not use hydrogen as a carrier gas. Thus, the p-type GaN-based semiconductor having a low resistance can be obtained with such devices.

The MQW structure of the active layer 9E may be, for example, a structure of five to six periods of InGaN/GaN. The In composition may vary depending on the intended emission wavelengths. The In concentration can be set to be from about 15% to about 20% for blue light (near the 450 nm) and to be about 30% for green light (near the 530 nm). If necessary, an electron-blocking layer (for example, an AlGaN layer) may be formed on the active layer 9E. In order to reduce the resistance, a surface (about the 10 nm) of the p-type semiconductor layer 9P may be a p-type highly-doped layer.

The first and second electrodes E1 and E2 may have a single-layer structure or a multi-layer structure containing at least one selected from the group consisting of Au, Ag, Pd, Pt, Ni, Ti, V, W, Cr, Al, Cu, Zn, Sn, and In.

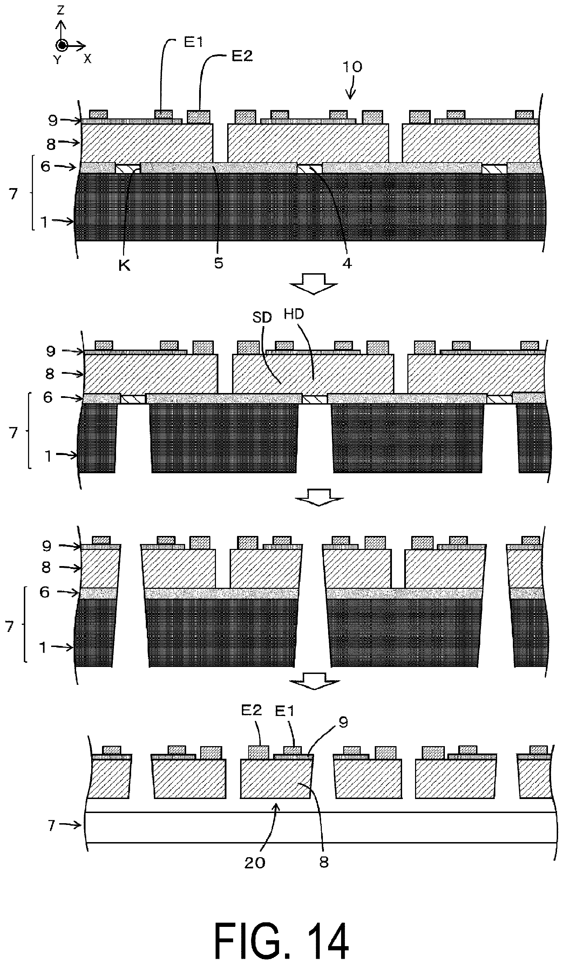

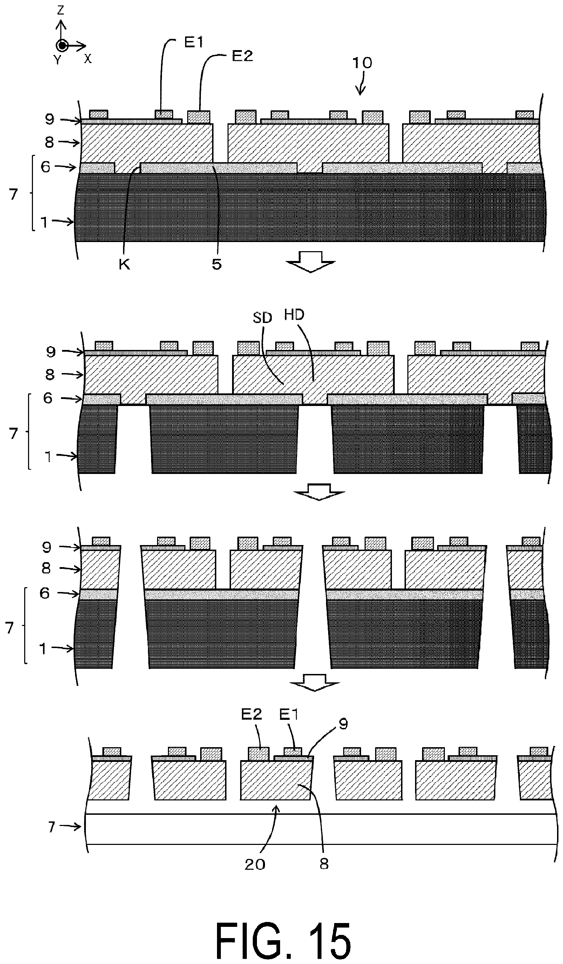

FIG. 14 and FIG. 15 are cross-sectional views each illustrating another example of the manufacturing method of the semiconductor device according to Example 1. In FIG. 8, although the underlying portion 4 is entirely formed on the main substrate 1, the configuration is not limited to this example. As illustrated in FIG. 14, the underlying portion 4 may be locally formed so as to overlap the opening portions K of the mask pattern 6 in plan view. As illustrated in FIG. 15, for example, a GaN substrate (bulk crystal of GaN) or a 6H-SiC substrate is used as the main substrate 1, so that the first semiconductor part 8 can also be grown using the upper surface of the main substrate 1 as a seed without providing the underlying portion 4.

When the first semiconductor part 8 is formed using the ELO method, the main substrate 1 and the template substrate 7 including the mask pattern 6 on the main substrate 1 may be used. The template substrate 7 may include a growth suppression region (for example, a region suppressing crystal growth in the Z direction) corresponding to the mask portion 5 and a seed region corresponding to the opening portion K. For example, the growth suppression region and the seed region may be formed on the main substrate 1, and the first semiconductor part 8 may be formed on the growth suppression region and the seed region by using the ELO method.

### Example 2

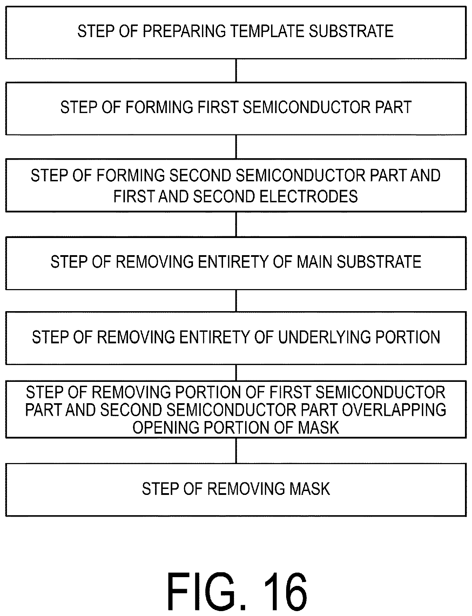

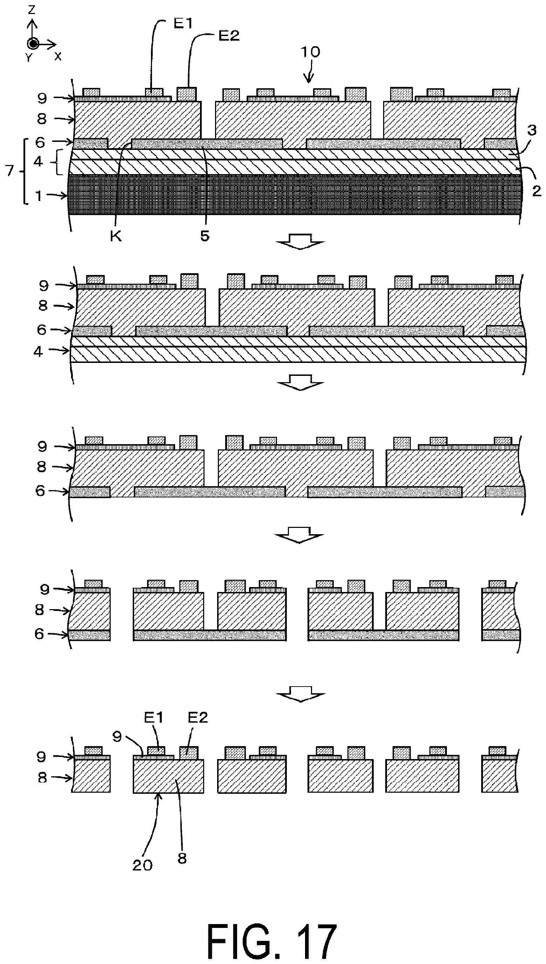

FIG. 16 is a flowchart illustrating an example of a manufacturing method of a semiconductor device according to Example 2. FIG. 17 is a cross-sectional view illustrating an example of the manufacturing method of the semiconductor device according to Example 2. In the manufacturing method of the semiconductor device in FIG. 16 and FIG. 17, a step of preparing the template substrate (substrate for ELO growth) 7 is performed. The template substrate includes the main substrate 1, the underlying portion 4, and the mask pattern 6 in this order, and the mask pattern 6 includes the mask portion 5 and the opening portions K. Thereafter, the first semiconductor part 8 is formed on the template substrate 7 by using the ELO method. Next, a step of forming the second semiconductor part 9 and the first and second electrodes E1 and E2 is performed.

Thereafter, a step of removing the entirety of the main substrate 1 and a step of removing the entirety of the underlying portion 4 are performed. Thereafter, the mask portion 5 that is a selective growth mask is used (caused to function) as an etching mask, and a step of removing portions of the first and second semiconductor parts 8 and 9 each overlapping a respective one of the opening portions K of the mask pattern 6 in plan view is performed. Thereafter, a step of removing the mask portion 5 by using, for example, hydrogen fluoride (HF) is performed. This can facilitate separation of the template substrate 7 and the first semiconductor part 8 from each other. The first and second semiconductor parts 8 and 9 and the like are singulated to form the plurality of the semiconductor devices 20.

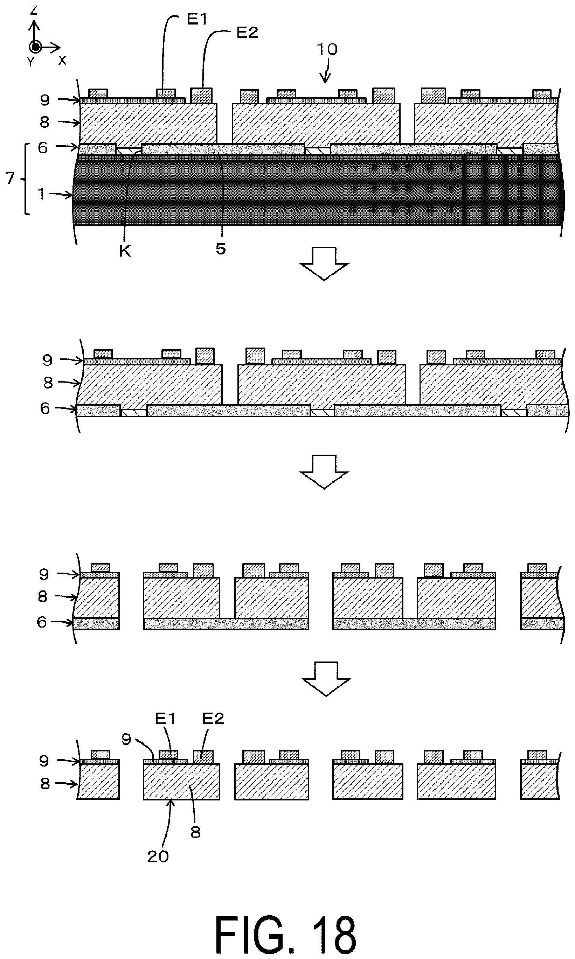

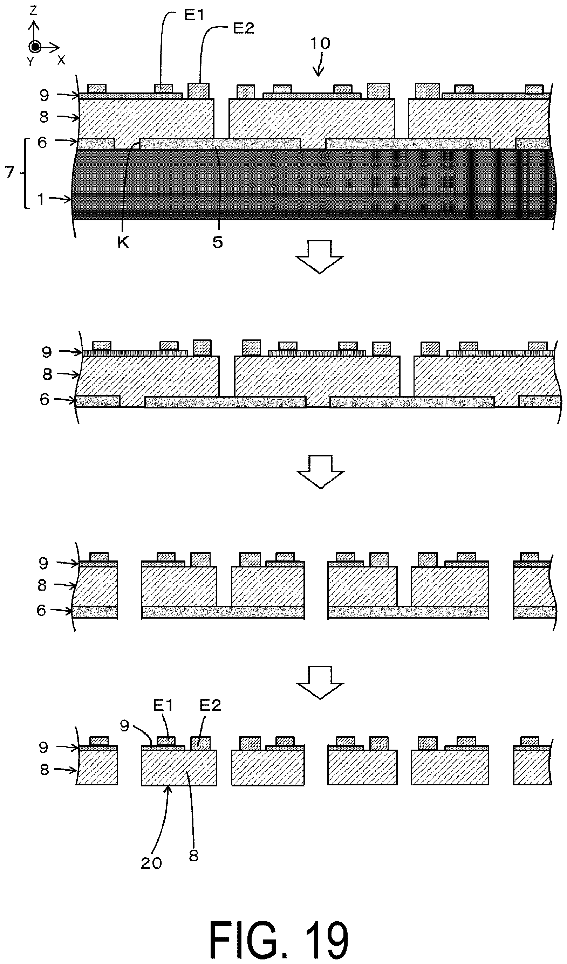

FIG. 18 and FIG. 19 are cross-sectional views each illustrating another example of the manufacturing method of the semiconductor device according to Example 2. In FIG. 17, although the underlying portion 4 is entirely formed on the main substrate 1, the configuration is not limited to this example. As illustrated in FIG. 18, the underlying portion 4 may be locally formed so as to overlap the opening portions K of the mask pattern 6 in plan view. As illustrated in FIG. 19, for example, a GaN substrate (bulk crystal of GaN) or a 6H-SiC substrate is used as the main substrate 1, so that the first semiconductor part 8 can also be grown using the upper surface of the main substrate 1 as a seed without providing the underlying portion 4.

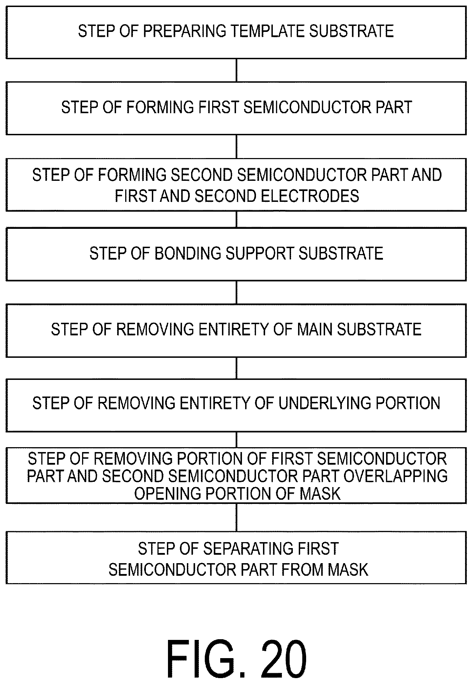

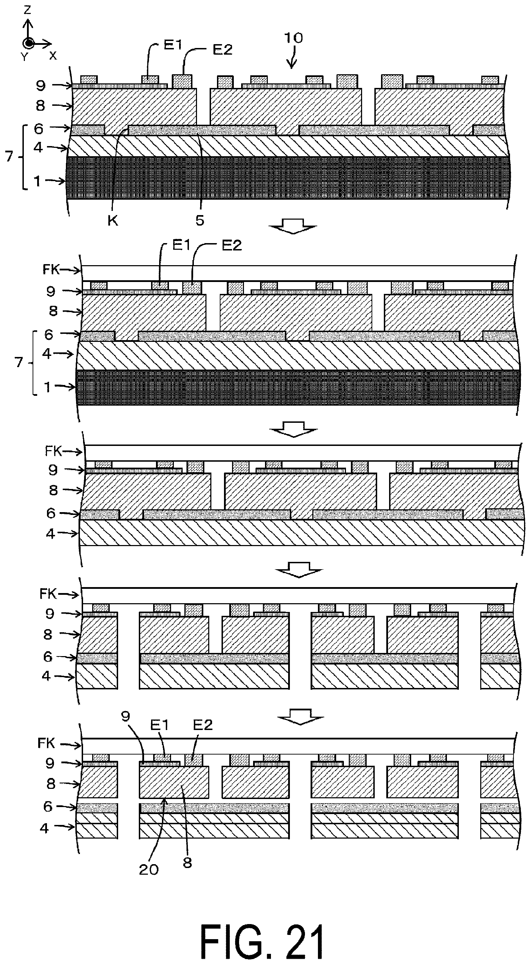

FIG. 20 is a flowchart illustrating another example of the manufacturing method of the semiconductor device according to Example 2. FIG. 21 is a cross-sectional view illustrating another example of the manufacturing method of the semiconductor device according to Example 2. In the manufacturing method of the semiconductor device illustrated in FIGs. 20 and 21, after the semiconductor substrate 10 including the first and second semiconductor parts 8 and 9 is formed, a support substrate FK is bonded to the opposite side of the main substrate 1. Thus, the first and second semiconductor parts 8 and 9 and the first and second electrodes E and E2 are held by the support substrate FK. Thereafter, the entirety of the main substrate 1 is removed. This facilitates handling after removing the main substrate 1. In this case, a mounting step can be omitted by using the support substrate FK as a mounting substrate (sub-mount substrate or drive substrate). The first and second semiconductor parts 8 and 9 and the like may be transferred from the support substrate FK to another mounting substrate.

### Example 3

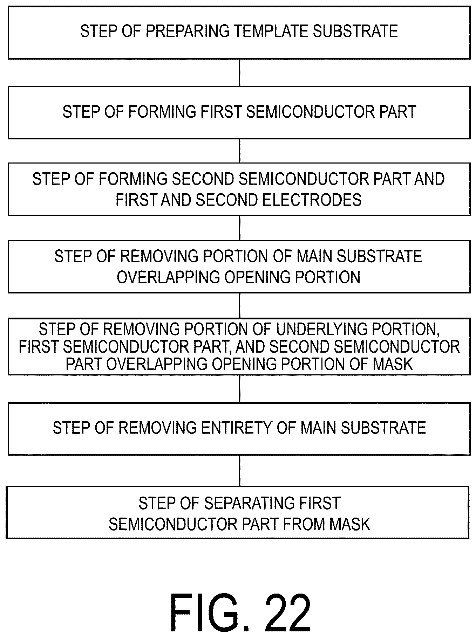

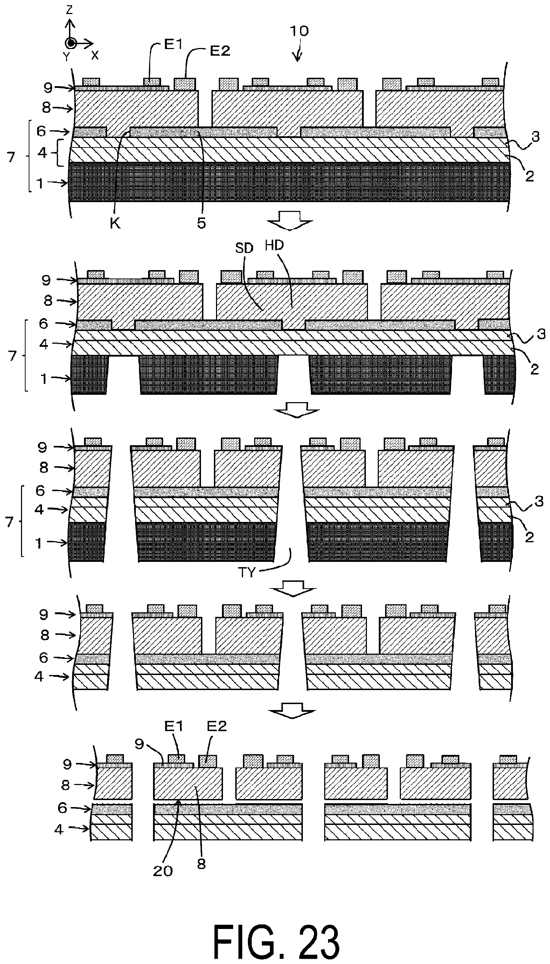

FIG. 22 is a flowchart illustrating an example of a manufacturing method of a semiconductor device according to Example 3. FIG. 23 is a cross-sectional view illustrating an example of the manufacturing method of the semiconductor device according to Example 3. In the manufacturing method of the semiconductor device in FIG. 22 and FIG. 23, a step of preparing the template substrate (substrate for ELO growth) 7 is performed. Thereafter, the first semiconductor part 8 is formed on the template substrate 7 by using the ELO method. Next, a step of forming the second semiconductor part 9 and the first and second electrodes E1 and E2 is performed. Thereafter, a step of removing a portion of the main substrate 1 overlapping the opening portions K of the mask pattern 6 in plan view is performed by etching (depth etching) the main substrate 1 from the back surface thereof. Thereafter, using the remaining portion of the main substrate 1 as an etching mask, a step of removing portions of the underlying portion 4, the first semiconductor part 8, and the second semiconductor part 9 overlapping a respective one of the opening portions K of the mask pattern 6 in plan view to form trenches TY extending in the Y direction is performed. Thereafter, a step of removing the entirety of the main substrate 1 and a step of separating the first semiconductor part 8 from the mask pattern 6 are performed.

The above-described embodiment and each of Examples have been presented for purposes of illustrations and descriptions, and not limitation. Based on these illustrations and descriptions, it will be apparent to those skilled in the art that many variations are possible.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, it is noted that a person skilled in the art can easily make various variations or modifications based on the present disclosure. Note that these variations or modifications are included within the scope of the present disclosure.

### REFERENCE SIGNS

1 Main substrate
3 Seed portion
4 Underlying portion
5 Mask portion
6 Mask pattern
7 Template substrate
8 First semiconductor part
9 Second semiconductor part
9E Active layer
20 Semiconductor device
30 Micro LED display (electronic device)
70 Manufacturing apparatus
72 Former
73 Machining portion
E1 First electrode
E2 Second electrode
K Opening portion
FK Support substrate

## Claims

1. A manufacturing method of a semiconductor device, comprising:
preparing a template substrate comprising a main substrate and a mask pattern, located above the main substrate and comprising a mask portion and an opening portion;
forming a first semiconductor part on the mask pattern;
removing a portion of the main substrate overlapping the opening portion in plan view; and
removing a portion of the first semiconductor part overlapping the opening portion in plan view.

2. The manufacturing method of a semiconductor device according to claim 1, further comprising:
partially removing the main substrate and removing the first semiconductor part by using a remaining portion of the main substrate as an etching mask.

3. The manufacturing method of a semiconductor device according to claim 1 or 2, further comprising:
removing the entirety of the main substrate before partially removing the first semiconductor part.

4. The manufacturing method of a semiconductor device according to claim 1, wherein
the entirety of the main substrate is removed and the first semiconductor part is removed by using the mask portion as an etching mask.

5. The manufacturing method of a semiconductor device according to any one of claims 1 to 4, further comprising:
forming a second semiconductor part in an upper layer of the first semiconductor part, wherein
a portion of the second semiconductor part overlapping the opening portion in plan view is removed.

6. The manufacturing method of a semiconductor device according to claim 5, wherein
the second semiconductor part is partially removed subsequently to the partially removing the first semiconductor part.

7. The manufacturing method of a semiconductor device according to any one of claims 1 to 6, wherein
in the preparing the template substrate, a template substrate comprising an underlying layer between the main substrate and the mask pattern is prepared, and the method further comprising:
removing at least a portion of the underlying layer overlapping the opening portion in plan view.

8. The manufacturing method of a semiconductor device according to claim 2, further comprising:
polishing a back surface of the main substrate to reduce the thickness before the partially removing the main substrate.

9. The manufacturing method of a semiconductor device according to any one of claims 1 to 8, wherein
the first semiconductor part contains a nitride semiconductor, and
in the partially removing the first semiconductor part, etching is performed from a (000-1) plane of the first semiconductor part.

10. The manufacturing method of a semiconductor device according to claim 4, further comprising:
supporting the first semiconductor part by a support substrate.

11. The manufacturing method of a semiconductor device according to claim 10, wherein the support substrate is a mounting substrate.

12. The manufacturing method of a semiconductor device according any one of claims 1 to 11, wherein
the first semiconductor part and the mask pattern are separated from each other after the partially removing the first semiconductor part.

13. The manufacturing method of a semiconductor device according to claim 1 or 2, wherein
the entirety of the main substrate is removed after the partially removing the first semiconductor part.

14. The manufacturing method of a semiconductor device according to any one of claims 1 to 13, wherein
the mask portion is a selective growth mask,
the first semiconductor part contains a GaN-based semiconductor, and
the main substrate is a silicon substrate or a silicon carbide substrate.

15. The manufacturing method of a semiconductor device according to claim 7, wherein
the underlying layer comprises a seed portion overlapping the opening portion in plan view,
in the partially removing the first semiconductor part, a coupling portion between the seed portion and the first semiconductor part is removed.

16. The manufacturing method of a semiconductor device according to claim 1, wherein
an anchor film in contact with the mask portion and an upper surface and a side surface of the first semiconductor part is formed before the partially removing the first semiconductor part.

17. A manufacturing apparatus of a semiconductor device, comprising:
a former configured to form a mask pattern comprising a mask portion and an opening portion in an upper layer of a main substrate and then form a first semiconductor part on the mask pattern by using an ELO method; and
a machining portion configured to remove at least a portion of the main substrate overlapping the opening portion in plan view and then remove a portion of the first semiconductor part overlapping the opening portion in plan view.

18. A semiconductor device comprising:
a first semiconductor part containing a GaN-based semiconductor; and
an active layer located in an upper layer of the first semiconductor part, wherein
the first semiconductor part comprises an upper surface that is a (0001) plane and a lower surface that is a (000-1) plane, and
a length of the upper surface of the first semiconductor part in a <11-20> direction is greater than a length of the lower surface of the first semiconductor part in the <11-20> direction.

19. The semiconductor device according to claim 18, further comprising:
a second semiconductor part comprising the active layer on the first semiconductor part; and
a first electrode in contact with the second semiconductor part and a second electrode in contact with the first semiconductor part.

20. The semiconductor device according to claim 19, wherein
the second semiconductor part comprises an upper surface that is a (0001) plane and a lower surface that is a (000-1) plane, and
a length of the upper surface of the second semiconductor part in a <11-20> direction is greater than a length of the lower surface of the second semiconductor part in the <11-20> direction.

21. An electronic device, comprising:
the semiconductor device according to any one of claims 18 to 20.
